# EUROPÄISCHE PATENTSCHRIFT

(11) **EP 2 450 143 B1**
(45) Veröffentlichungstag und Bekanntmachung des Hinweises auf die Patenterteilung: **20.04.2016**
(21) Anmeldenummer: 11188284.1
(22) Anmeldetag: 08.11.2011
(51) Int. Cl.: B23K 1/00, B23K 3/02, B23K 3/047, H05K 3/34

(54) **Lötkopf für eine Bügellötvorrichtung mit einem Gehäuse für den Transformator und die Halterung**
Soldering head for a bracket soldering device with a housing for the transformator and the holding means
Tête de brasage pour dispositif de brasage avec un boitier pour le tranformateur et le dispositif de maintien

(30) Priorität: 09.11.2010 DE 202010015175 U
(43) Veröffentlichungstag der Anmeldung: 09.05.2012
(73) Patentinhaber: Neuschäfer Elektronik GmbH, 35066 Frankenberg (DE)
(72) Erfinder: Neuschäfer, Wilfried, 35066 Frankenberg (DE)
(74) Vertreter: Patentanwälte Olbricht Buchhold Keulertz

(56) Entgegenhaltungen:
- DE-A1- 3 044 345
- US-A- 2 405 866
- US-A- 2 715 670
- US-A- 2 931 881
- US-A- 3 992 605
- US-A- 5 101 094
- US-A- 5 329 085
- US-A1- 2001 004 982
- US-A1- 2005 247 692

## Beschreibung

Die Erfindung betrifft einen Lötkopf für eine Bügellötvorrichtung gemäß dem Oberbegriff von Anspruch 1, siehe, z.B., US 2 405 866 A.

Elektronische Bauelemente, wie z.B. Litzen, Flexfolien, Flachbandkabel oder Flachleiter, aber auch flexible Leiterplatten, OLEDs, LCDs u.dgl., werden gewöhnlich durch Löten mit anderen Bauelementen, beispielsweise Steckverbindern oder Leiterplatten, elektrisch verbunden. Hierbei verwendet man meist Bügellötvorrichtungen, die als Lötwerkzeug einen Lötbügel (auch Thermode genannt) aufweisen, der seine Wärme über Kontaktdruck auf die mit einem Lot versehenen Anschlussenden der Bauelemente überträgt (siehe dazu beispielsweise DD 147 512 C oder EP 0 378 113 A2). Der Lötbügel ist lösbar an einem Lötkopf montiert, der mit einem einachsigen pneumatischen oder motorischen Antrieb versehen ist. Die notwendige Anpresskraft wird kann über ein Federpaket erzeugt werden (siehe z.B. DE 43 30 467 C1).

Für die Ausführung des Lötvorgangs wird zunächst Lot auf die gewünschten Kontaktstellen der Bauelemente aufgebracht. Anschließend wird das anzulötende Bauteil über der Kontaktstelle des anderen Bauteils positioniert und der Lötbügel mit einer Kontaktfläche kalt aufgesetzt, so dass beide Bauteile gegeneinander gepresst werden. Nach Erreichen der von dem Federpaket voreingestellten Andrückkraft wird der Lötbügel innerhalb einer vorgegebenen Zeit auf eine definierte Temperatur erhitzt. Diese liegt über der Schmelztemperatur des Lotes und wird für eine bestimmte Prozesszeit gehalten. Anschließend wird der Lötbügel abgekühlt und - sobald das Lot sicher erstarrt ist - von der Lötstelle abgehoben (siehe dazu DE 28 18 958 A1).

Zum Aufheizen des Lötbügels wird oft ein Hochstromnetzteil verwendet, das bei relativ niedriger Spannung von etwa 1 bis 3 V einen Strom von 200 bis 300 A erzeugt, der unmittelbar durch den Lötbügel fließt und diesen innerhalb der vorgegebenen Zeit auf die gewünschte bzw. notwendige Temperatur bringt. Die Stromzuführung zu dem Lötbügel erfolgt über Hochstromkabel, die einen relativ großen Leitungsquerschnitt aufweisen. Derartige Kabel sind jedoch in hohem Maße unflexibel, so dass der gesamte Lötkopf entsprechend unbeweglich und nur mühsam zu handhaben ist, was insbesondere in automatisierten Systemen zu Nachteilen führt. Problematisch ist ferner, dass die verwendeten Transformatoren sehr groß und schwer sind.

Um dem zu begegnen, schlägt EP 0 436 969 A1 die Verwendung eines Hochfrequenz-Transformators vor, der in unmittelbarer Nähe zur Thermode bzw. zum Lötbügel angeordnet ist. Hierzu ist ein kreuzförmiger Trägerrahmen vorgesehen, der vier nach außen gerichtete Ausleger aufweist. Jeder Ausleger bildet mit gegenüberliegend ausgerichteten E-förmigen Elementen einen Transformatorkern mit je einer Ausnehmung, in die ein ebenfalls kreuzförmiger Spulenhalter eingesetzt ist. Dieser weist endseitig vier abstehende Schenkelpaare auf, die durch die Ausnehmungen des Transformatorkerns hindurch ragen und jeweils eine Spule zwischen sich aufnehmen. Jede Spule ist derart zwischen den Schenkeln der Schenkelpaare angeordnet, dass sie innerhalb der Ausnehmung des Transformatorkerns liegen. Jedes Schenkelpaar trägt endseitig einen Halter, an denen die Lötbügel befestigt sind.

Einen vergleichbaren Aufbau zeigt DE 30 44 345 A1. Der darin offenbarte Schweißkopf besitzt ebenfalls einen Hochfrequenz-Transformator, der in unmittelbarer Nähe eines Trägerelements für die Thermode angeordnet ist, wobei ein Teil des Trägerelements elektrisch in Reihe mit einer Sekundärschleife des Transformators geschaltet ist. Der Primärkreis des Transformators wird von einem Stromversorgungsgenerator gespeist, dessen Arbeitsbereich ebenfalls im Hochfrequenzbereich liegt.

US 2 405 866 A zeigt eine Bügellötvorrichtung, die in einem Handgerät untergebracht ist, wobei ein Lötbügel lösbar an einer Halterung befestigt ist, die in einer Stirnseite des Gehäuses angeordnet ist. Die Halterung ist dabei elektrisch leitend mit einer Sekundärwicklung eines Transformators verbunden, dessen Primärwicklung an eine Stromversorgung anschließbar ist. Über einen Handschalter 72 wird dabei die Stromversorgung der Primärwicklung gesteuert.

Aus US 2 715 670 A ist eine Bügellötvorrichtung bekannt, die ein Gehäuse aufweist, in dem ein Transformator angeordnet ist, dessen Primärwicklung an eine Stromversorgung anschließbar ist. Die Sekundärwicklung ist dabei aus dem Gehäuse herausgeführt und weist an ihrem Ende eine Halterung auf, an der ein Lötbügel lösbar befestigbar ist.

D3 (US 5 101 094 A) offenbart eine Vorrichtung zum Schneiden von Textilien, die einen bügelförmigen Heizdraht aufweist, der an einer Halterung festlegbar ist. Über elektrische Versorgungskabel kann dabei ein Strom durch den Heizdraht geleitet werden, der sich dadurch entsprechend erwärmt.

US 2 931 811 A zeigt eine Löteinrichtung mit einem pistolenförmigen Gehäuse, in dem ein Transformator angeordnet ist, dessen Primärwicklung mit Wechselstrom versorgt wird, sobald ein Handtaster betätigt wird. Eine Sekundärwicklung ist aus dem Gehäuse herausgeführt und endet in einem Halter, an dem ein Lötbügel lösbar befestigbar ist.

Ziel der Erfindung ist es, die Nachteile des Standes der Technik zu überwinden und einen verbesserten Lötkopf für eine Bügellötvorrichtung zu schaffen, die mit einfachen Mitteln kostengünstig aufgebaut ist und leicht zu handhaben ist. Der Lötkopf soll Insbesondere einen verbesserten Prozessablauf ermöglichen und auch höheren sowie dauerhaften Belastungen problemlos standhalten.

Hauptmerkmale der Erfindung sind im kennzeichnenden Teil von Anspruch 1 angegeben. Ausgestaltungen sind Gegenstand der Ansprüche 2 bis 10.

Bei einem Lötkopf für eine Bügellötvorrichtung, mit einem Lötbügel, der lösbar an einer Halterung festlegbar ist, und mit einem Transformator, der eine Primärwicklung und eine Sekundärwicklung aufweist, wobei die Primärwicklung des Transformators an eine Stromversorgung anschließbar ist und wobei der Lötbügel und die Halterung die Sekundärwicklung des Transformators bilden, sieht die Erfindung vor, dass die Halterung und der Transformator in einem Gehäuse angeordnet sind.

Dadurch bildet der Lötkopf eine in sich geschlossene kompakte Einheit, die einfach zu handhaben ist und die problemlos in einer automatisierten Bügellötvorrichtung eingesetzt werden kann. Beispielsweise lässt sich der Lötkopf mit dem Gehäuse unmittelbar an einer Linearführung oder Antriebseinheit montieren, die den Lötbügel rasch und präzise in Position bringt und die zu verlötenden Bauteile mit einer definierten Kraft beaufschlagt, bevor der Lötvorgang beginnt. Ferner kann der Lötkopf ohne großen Aufwand schnell ausgewechselt werden, z.B. wenn ein Defekt aufgetreten ist oder wenn ein anderer Transformator oder ein anderer Lötbügel verwendet werden soll. Der gesamte Montageaufwand wird deutlich reduziert.

Die für die Erwärmung des Lötbügels notwendige elektrische Leistung wird nicht mehr extern erzeugt, sondern innerhalb des Lötkopf-Gehäuses und damit in unmittelbarer Nähe zum Lötbügel. Steife und schwere Stromzuleitungen mit großen Leitungsquerschnitten, die eine Bewegung des Lötkopfes behindern könnten, sind damit nicht mehr erforderlich. Dadurch treten auch keine Belastungen mehr in den Übergabestellen der Hochstromanschlüsse auf, was die Betriebssicherheit der gesamten Vorrichtung erhöht. Das Gehäuse schützt ferner sowohl den Transformator als auch die Halterung für den Lötbügel, so dass diese nicht berührt werden können. Auch Beschädigungen werden wirksam vermieden. Der Lötkopf kann vielmehr innerhalb der Bügellötvorrichtung stets schnell und präzise bewegt werden, was sich günstig auf den Prozessablauf und die Taktzeiten auswirkt. Ferner werden die Herstell- und Betriebskosten der Bügellötvorrichtung deutlich gesenkt.

Eine wichtige Weiterbildung der Erfindung sieht vor, dass die Primärwicklung des Transformators an eine in dem Gehäuse integrierte elektronische Schaltung angeschlossen ist, wobei die elektronische Schaltung beispielsweise ein Netzteil ist oder bildet. Der Lötkopf bildet damit eine Art Bügellötgenerator, der innerhalb des Gehäuses die für die Erwärmung des Lötbügels notwendige Energie selbst erzeugt. Starre Zuleitungen sind damit nicht mehr notwendig, denn der Lötkopf kann mit seiner elektronischen Schaltung an eine gewöhnliche Niederspannungszuleitung angeschlossen werden. Dadurch können in den Zuleitungen auch keine Leistungsverluste mehr auftreten, was sich äußerst günstig auf den Wirkungsgrad auswirkt.

Der Lötbügel, die Halterung, der Transformator und die elektronische Schaltung bilden folglich eine Einheit, die kostengünstig und kompakt aufgebaut ist und als vormontierte Baueinheit geliefert werden kann. Dadurch ergeben sich weitere Vorteile in der Handhabung, denn der Montage- und Rüstaufwand wird auf ein Minimum reduziert. Beispielsweise lässt sich der Lötbügel rasch und bequem austauschen, indem der gesamte Lötkopf von der Lötvorrichtung abgenommen wird. Während der Lötbügel des abgenommenen Lötkopfes gewechselt oder gereinigt wird, kann unmittelbar ein anderer Lötkopf mit einem neuen Lötbügel montiert werden, so dass nur noch minimale Betriebsunterbrechnungen auftreten.

In einer weiteren Ausführungsform sieht die Erfindung vor, dass der Transformator einen Transformatorkern aufweist, der mit einer Öffnung zur Durchführung der Halterung versehen ist. Die Halterung und der daran festzulegende Lötbügel können damit als Spulenwicklung unmittelbar durch den Transformatorkern bzw. Spulenkern geführt werden, d.h. die Halterung und der Lötbügel bilden die Sekundärwicklung des Transformators. Dadurch wird der für die Erwärmung des Lötbügels notwendige Strom unmittelbar im Lötbügel erzeugt, der nicht weiter über separate Drahtzuleitungen an eine Spule oder an eine sonstige Schaltung angeschlossen werden muss.

Um den Lötkopf rasch an eine externe Spannungszuleitung anschließen zu können, ist in oder an dem Gehäuse ein elektrischer Anschluss für die Primärwicklung des Transformators oder für die elektronische Schaltung vorgesehen. Die kompakte Baueinheit aus Lötbügel, Halterung, Transformator und elektronischer Schaltung lässt damit äußerst einfach handhaben und ebenso einfach und rasch montieren.

Gemäß einer weiteren wichtigen Weiterbildung der Erfindung ist das Gehäuse aus einem wärmeleitfähigen Material gefertigt. Dadurch kann die von der elektronischen Schaltung und/oder von dem Transformator erzeugte Wärme unmittelbar nach außen abgeführt werden. Zusätzliche Kühlrippen auf oder an dem Gehäuse können diesen Effekt verstärken.

Besondere Vorteile ergeben sich ferner, wenn an oder in dem Gehäuse ein weiterer Anschluss für die Zuführung von Luft vorgesehen ist, wobei in dem Gehäuse Luftaustrittsöffnungen ausgebildet sind. Dadurch können die elektronische Schaltung und der Transformator nicht nur zusätzlich, sondern auch gezielt gekühlt werden, indem die durch das Gehäuse hindurchströmende Luft planmäßig über kritische oder temperaturempfindliche Bauteile geführt wird.

Eine weitere wichtige Ausgestaltung der Erfindung sieht vor, dass zumindest eine Luftaustrittsöffnung im Bereich des Lötbügels angeordnet ist. Dadurch wird nicht nur das Innere des Gehäuses gekühlt. Die zur Kühlung vorgesehene Luft kann vielmehr auch gezielt dafür eingesetzt werden, um den Lötbügel nach dem Lötvorgang abkühlen zu lassen. Gleichzeitig entsteht ein Reinigungseffekt, der den Lötbügel vor Verunreinigungen und Ablagerungen schützt. Sind in dem Gehäuse mehrere Luftaustrittsöffnungen vorgesehen, kann für die Luftaustrittsöffnung im Bereich des Lötbügels ein separater Anschluss für die Zuführung von Luft vorgesehen sein, so dass die Kühlung der elektronischen Schaltung und des Transformators unabhängig von der Kühlung des Lötbügels gesteuert werden kann.

Der Lötbügel weist zweckmäßig eine Kontaktfläche für ein zu verlötendes Bauelement auf, wobei die Kontaktfläche des Lötbügels zumindest abschnittsweise profiliert ausgebildet sein kann. Dadurch wird verhindert, dass das Bauteil während des Andrückens auf eine zugeordnete Kontaktfläche verrutscht oder verkantet.

Der Lötbügel kann ferner im Bereich der Kontaktfläche eine Verdickung oder Verstärkung aufweisen. Diese kann Temperaturunterschiede beim Aufheizen ausgleichen. Durch die bevorzugt in der Mitte des Lötbügels ausgebildete Verdickung oder Verstärkung wird eine längere Aufheizzeit benötigt. Dadurch entsteht eine gleichmäßige Temperaturverteilung, was sich günstig auf den Lötvorgang auswirkt.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine schematische Darstellung eines erfindungsgemäßen Lötkopfs für eine Bügellötmaschine;
- Fig. 2: eine Ausführungsform eines erfindungsgemäßen Lötkopfs für eine Bügellötmaschine;
- Fig. 3: ein Lötbügel für einen erfindungsgemäßen Lötkopf.

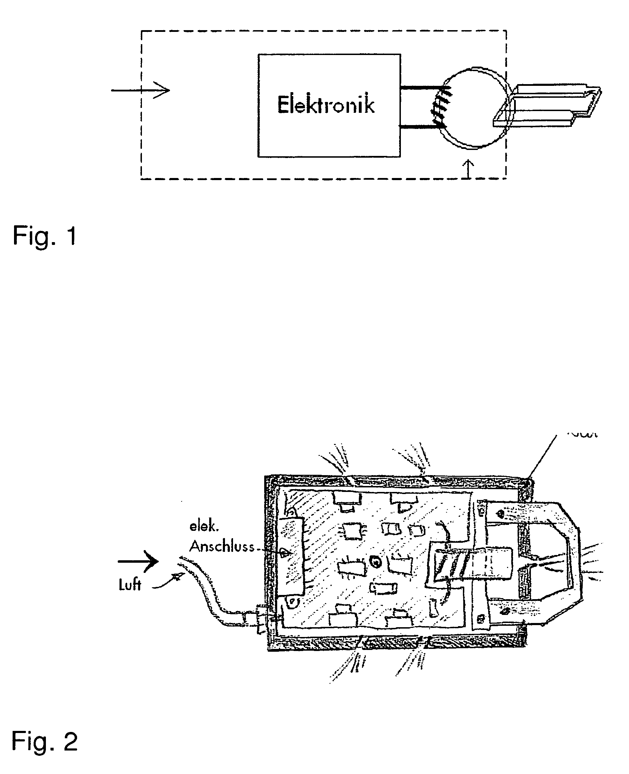

Der in Fig. 1 allgemein mit 10 bezeichnete Lötkopf ist für eine (nicht weiter dargestellte) Bügellötvorrichtung ausgebildet. Er hat einen Lötbügel 20, der lösbar an einer bügel- oder stabförmigen Halterung 30 festlegbar ist, beispielsweise mittels Schrauben 34 (siehe Fig. 2). Die Halterung 30 durchragt einen Spulenkern 51, der zusammen mit einer elektronischen Schaltung 80 in einem Gehäuse 70 angeordnet ist. Auf dem Spulenkern 51 sitzt eine Drahtwicklung 52, deren Enden 521, 522 an die elektronische Schaltung 80 angeschlossen sind. An seinem dem Lötbügel 20 abgewandten Ende weist das Gehäuse 70 einen elektrischen Anschluss 72 auf, z.B. eine Buchse für einen Steckverbinder, der eine (nicht gezeigte) Niederspannungszuleitung mit der elektronischen Schaltung 80 verbindet.

Die Drahtwicklung 52 auf dem Spulenkern 51 bildet eine Primärwicklung, während der Lötbügel 20 zusammen mit der Halterung 30 eine in sich geschlossene Sekundärwicklung 54 ist, die den Spulenkern 51 gegenüberliegend zur Primärwicklung 52 umschließt. Um eine geschlossene Drahtwicklung zu bilden, ist der Lötbügel 20 mit seinen Schenkeln 22, 23 seitlich von dem Spulenkern 51 mit der Halterung 30 verbunden, die hierzu einen im Wesentlichen stabförmigen Grundkörper 32 aufweist.

Man erkennt, dass der Spulenkern 51, die Primärwicklung 52 und die Sekundärwicklung 54 einen Transformator 50 bilden, der gemeinsam mit der elektronischen Schaltung 80 in dem Gehäuse 70 integriert ist. Die Primärwicklung 52 wird über die elektronische Schaltung 80 und den elektrischen Anschluss 72 an eine externe Energieversorgung angeschlossen, vorzugweise an eine Niederspannungsquelle oder an einen Netzanschluss. Bei der elektronischen Schaltung 80 handelt es sich vorzugweise um ein geregeltes Netzteil oder einen Stromgenerator, das bzw. der in der Primärwicklung 52 einen definierten Strom erzeugt. Dadurch entsteht aufgrund elektromagnetischer Induktion innerhalb des Kerns 51 ein magnetischer Fluss, der innerhalb der Sekundärwicklung 54 und damit innerhalb des Lötbügels 20 einen relativ hohen Strom generiert. Der aus einem Widerstandsmaterial gefertigte Lötbügel 20 wird erhitzt und kann für Lötarbeiten verwendet werden. Die Halterung 30 hingegen ist aus einem gut wärmeleitenden Material gefertigt, damit sich diese nur mäßig erwärmt und sich die Hitze in dem Lötbügel 20 konzentrieren kann.

Die Bügellötvorrichtung arbeitet bevorzugt nach dem Pulse-Heat-Verfahren, wobei die in dem Lötbügel 20 eingebrachte Energie über eine Pulsweitenmodulation geregelt wird. Die hierfür notwendige Steuerung, z.B. eine speicherprogrammierbare Steuerung (SPS), kann außerhalb des Gehäuses 70 angeordnet sein. Man kann eine geeignete Steuerschaltung aber auch ganz oder teilweise in der elektronischen Schaltung 80 integrieren, während nur eine Bedieneinheit außerhalb angeordnet ist.

In der Ausführungsform von Fig. 2 sind gleiche Bauteile mit gleichen Bezugszeichen benannt.

Die elektronische Schaltung 80 ist auf einer Leiterplatte 81 aufgebracht, die in dem Gehäuse 70 befestigt ist. Auf der Leiterplatte 81 sind die (nicht näher bezeichneten) Komponenten der elektronischen Schaltung 80 aufgebracht, die z.B. als Leistungselektronik ausgebildet sein kann und die Primärwicklung 52 des Transformators 50 mit einem definierbaren Strom beaufschlagt. Über den Transformatorkern 51 wird in der nur eine Wicklung aufweisenden Sekundärwicklung 54 ein gleichfalls definierter Strom generiert, der im Zeitablauf innerhalb des Lötbügels 20 einen Heizstrom und dadurch ein definiertes Temperaturprofil erzeugt. Mit diesem wird der Lötvorgang durchgeführt, so dass die zu verbindenden Bauteile stets sicher und zuverlässig elektrisch kontaktiert werden.
der bevorzugt auf der Leiterplatte 81 angeordnete und als Buchse ausgebildete elektrische Anschluss 72 kann nicht nur eine Verbindung zu einem Netzanschluss herstellen. Es können innerhalb der Buchse auch weitere Leitungen vorgesehen sein, beispielsweise für ein Signal, das von einem (nicht gezeigten) Temperaturfühler erzeugt wird und mit dem die Temperatur am Lötbügel kontrolliert werden kann. Denkbar sind auch Leitungen, die Informationen zwischen der elektronischen Schaltung 80 und einer extern ausgebildeten Steuereinheit und/oder Bedieneinheit austauschen. Mit dem elektrischen Anschluss 72 kann der Lötkopf 10 jederzeit rasch und bequem in einer Bügellötvorrichtung montiert werden.

Wie Fig. 2 zeigt, ist an dem Gehäuse 70 ein weiterer Anschluss 74 vorgesehen. Dieser ist mit einem Luftschlauch 75 verbunden, über den Luft in das Gehäuse 70 eingeblasen werden kann. Die Luft kühlt die elektronische Schaltung 80 und den Transformator 50, so dass diese während des Betriebes nicht überhitzen können.

Damit die mit dem Buchstaben L angedeutete Luft aus dem Gehäuse 70 wieder austreten kann, sind seitlich in dem Gehäuse 70 mehrere Öffnungen 76 eingebracht. Diese bilden Luftaustrittsöffnungen, so dass die von der Luft aufgenommene Wärme aus dem Gehäuse 70 heraus transportiert werden kann. Die Luftaustrittsöffnungen 76 müssen nicht zwingend seitlich in dem Gehäuse 70 ausgebildet sein. Man kann die Öffnungen 76 auch an der Ober- oder Unterseite des Gehäuses 70 ausbilden, insbesondere im Ganzen derart, dass die über den Anschluss 74 eingeleitete Luft gezielt über bestimmte Bauteile der elektronischen Schaltung 80 strömt, damit diese oder der Transformator 50 zielgerichtet gekühlt wird.

Zweckmäßig ist das Gehäuse 70 aus einem wärmeleitfähigen Material gefertigt. Auch darüber kann die von der elektronischen Schaltung 80 und dem Transformator 50 erzeugte Wärme nach außen abgegeben werden.

Im Bereich des Lötbügels 20 ist in dem Gehäuse 70 eine weitere Luftaustrittsöffnung 78 eingebracht. Diese ist derart angeordnet und ausgerichtet, das nach dem Abschalten der Stromzufuhr und damit nach dem Abschalten der Heizung für den Lötbügel 20 über den Luftanschluss 74 in das Gehäuse 70 eintretende Luft über den Lötbügel 20 strömen kann. Dadurch wird der Lötbügel 20 gezielt gekühlt, sobald der Lötvorgang abgeschlossen und der Eintrag von Wärme in die zu verlötenden Bauteile beendet ist. Durch das Kühlen des Lötbügels 20 kann das auf den Bauteilen aufgebrachte Lot schneller erstarren und der Lötbügel 20 kann vorzeigt angehoben und zur Seite gefahren werden. Der Lötvorgang lässt sich mithin beschleunigen.

Der Lötbügel 20 weist für den Kontakt mit den zu verlötenden Bauelementen eine Kontaktfläche 26 auf, die bei Bedarf profiliert sein kann. Damit sich jedoch der Lötbügel 20 entlang der Kontaktfläche 26 mit einer möglichst gleichmäßigen Temperaturverteilung erwärmen kann, ist ergänzend oder alternativ im Bereich der Kontaktfläche 26 eine Verdickung oder Verstärkung 28 vorgesehen. Diese sorgt bereits während des Aufheizens für eine gleichmäßige Temperaturverteilung, die bis zum Ende des Lötvorgangs erhalten bleibt.

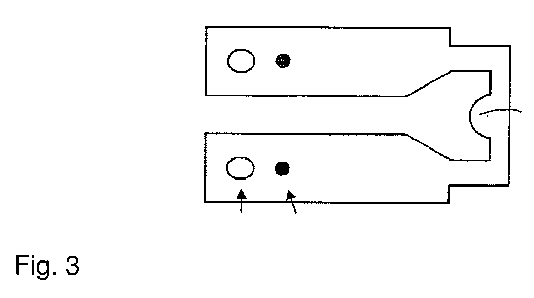

In den Schenkeln 22, 23 des Lötbügels 20 sind - wie Fig. 3 weiter zeigt - endseitig Schraublöcher 24 vorgesehen, welche beim Festlegen des Lötbügels 20 an dem Halteelement 30 dessen Schrauben 34 aufnehmen. Zusätzliche Führungsbohrungen 25 erleichtern das Einsetzen und Festschrauben des Lötbügels 20, insbesondere dann wenn auf dem Halteelement 30 korrespondierende Zapfen 35 ausgebildet sind.

Die Erfindung ist nicht auf eine der vorbeschriebenen Ausführungsformen beschränkt, sondern in vielfältiger Weise abwandelbar. So kann man in der Öffnung 55 des Transformatorkerns 51 mehrere Halteelemente 30 vorsehen, die jeweils mit einem Lötbügel 20 eine eigene Sekundärwicklung 54 bilden. Oder man verwendete mehrere Transformatorkerne 51, die mit ihren Primärwicklungen 52 einzeln an die elektronische Schaltung 80 angeschlossen sind Auf diese Weise können mehrere Bauelemente gleichzeitig gelötet werden. Denkbar ist ferner an einer Halterung 30 mehrere Lötbügel 20 zu befestigen, was je nach der Geometrie oder Anordnung der zu verlötenden Bauelemente zweckmäßig sein kann.
- L: Luft

- 10: Lötkopf
- 20: Lötbügel
- 22: Schenkel
- 23: Schenkel
- 24: Schraubloch
- 25: Führungsbohrung
- 26: Kontaktfläche
- 28: Verdickung/Verstärkung
- 30: Halterung
- 32: Grundkörper
- 34: Schraube
- 35: Zapfen
- 50: Transformator
- 51: Transformatorkern /Spulenkern
- 52: Primärwicklung/Drahtwicklung
- 54: Sekundärwicklung
- 55: Öffnung
- 70: Gehäuse
- 72: elektrischer Anschluss
- 74: weiterer Anschluss
- 75: Luftschlauch
- 76: Luftaustrittsöffnung
- 78: Luftaustrittsöffnung
- 80: elektronische Schaltung
- 81: Leiterplatte

## Patentansprüche

1. Lötkopf (10) für eine Bügellötvorrichtung,
a) mit einem Lötbügel (20), der lösbar an einer Halterung (30) festlegbar ist, und
b) mit einem Transformator (50), der einen Spulenkern (51) und eine auf dem Spulenkern (51) gelagerte eine Draht wicklung (52) und eine Sekundärwicklung (54) aufweist,
c) wobei die Draht wicklung (52) des Transformators (50) an eine Stromversorgung anschließbar ist, und
d) wobei der Lötbügel (20) und die Halterung (30) die Sekundärwicklung (54) des Transformators (50) bilden,
e) wobei die Halterung (30) und der Transformator (50) in einem Gehäuse (70) angeordnet sind,
f) wobei die Primärwicklung (54) des Transformators (50) über eine in dem Gehäuse (70) integrierte elektronische Schaltung (80) an die Stromversorgung angeschlossen ist
**dadurch gekennzeichnet,**
g) dass der Transformator (50) einen Transformatorkern (51) aufweist, der mit einer Öffnung (55) zur Durchführung der Halterung (30) versehen ist,
h) dass der Lötbügel (20) zusammen mit der Halterung (30) eine in sich geschlossene Sekundärwicklung (54) ist, die den Spulenkern (51) gegenüberliegend zur Primärwicklung (52) umschließt,
i) wobei der Lötbügel (20) mit Schenkeln (22, 23) seitlich von dem Spulenkern (51) mit der Halterung (30) verbunden ist, die hierzu einen im Wesentlichen stabförmigen Grundkörper (32) aufweist, und
j) dass die Bügellötvorrichtung nach dem Pulse-Heat-Verfahren arbeitet, wobei die in dem Lötbügel (20) eingebrachte Energie über eine Pulsweitenmodulation regelbar ist.

2. Lötkopf nach Anspruch 1, **dadurch gekennzeichnet, dass** die elektronische Schaltung (80) ein Netzteil ist oder bildet.

3. Lötkopf nach Anspruch 1 oder 2, **dadurch gekennzeichnet, dass** in oder an dem Gehäuse (70) ein elektrischer Anschluss (72) für die Primärwicklung (54) des Transformators (50) oder für die elektronische Schaltung (80) vorgesehen ist.

4. Lötkopf nach einem der Ansprüche 1 bis 3, **dadurch gekennzeichnet, dass** das Gehäuse (70) aus einem wärmeleitfähigen Material gefertigt ist.

5. Lötkopf nach einem der Ansprüche 1 bis 4, **dadurch gekennzeichnet, dass** an oder in dem Gehäuse (70) ein weiterer Anschluss (74) für die Zuführung von Luft vorgesehen ist.

6. Lötkopf nach einem der Ansprüche 1 bis 5, **dadurch gekennzeichnet, dass** in dem Gehäuse (70) Luftaustrittsöffnungen (76, 78) ausgebildet sind.

7. Lötkopf nach Anspruch 6, **dadurch gekennzeichnet, dass** zumindest eine Luftaustrittsöffnung (78) im Bereich des Lötbügels (20) angeordnet ist.

8. Lötkopf nach einem der Ansprüche 1 bis 7, **dadurch gekennzeichnet, dass** der Lötbügel (20) eine Kontaktfläche (26) für ein zu verlötendes Bauelement aufweist.

9. Lötkopf nach Anspruch 8, **dadurch gekennzeichnet, dass** die Kontaktfläche (26) des Lötbügels (20) zumindest abschnittsweise profiliert ausgebildet ist.

10. Lötkopf nach Anspruch 8 oder 9, **dadurch gekennzeichnet, dass** der Lötbügel (20) im Bereich der Kontaktfläche (26) eine Verdickung oder Verstärkung (28) aufweist.

## Claims

1. Soldering head (10) for a hot bar soldering device,
a) with a soldering bar (20) that can be detachably fixed to a mount (30) and
b) with a transformer (50), having a core (51) and a wire winding (52) seated on the core (51) and a secondary winding (54),
c) in which the wire winding (52) of the transformer (50) can be connected to a supply of electricity and
d) in which the soldering bar (20) and the mount (30) form the secondary winding (54) of the transformer (50),
e) in which the mount (30) and the transformer (50) are arranged within a housing (70),
f) in which the primary winding (54) of the transformer (50) is connected to the supply of electricity via an electronic circuit (80) integrated in the housing (70) and
**characterised in that**
g) the transformer (50) has a core (51) provided with an opening (55) to allow passage of the mount (30),
h) the soldering bar (20) together with the mount (30) is a closed secondary winding (54) that surrounds the core (51) opposite the primary winding (52),
i) in which the soldering bar (20) is connected to the mount (30) with shanks (22, 23) either side of the core (51), the mount (30) thereby presenting the basic shape of a bar (32),
j) the hot bar soldering device operates according to the pulse heat method, in which the energy supplied to the soldering bar (20) can be regulated by pulse width modulation.

2. Soldering head according to claim 1, **characterised in that** the electronic circuit (80) is or forms a power supply.

3. Soldering head according to claim 1 or 2, **characterised in that** in or on the housing (70), an electrical connection (72) is provided for the primary winding (54) of the transformer (50) or for the electronic circuit (80).

4. Soldering head according to one of claims 1 to 3, **characterised in that** the housing (70) is made of a heat conducting material.

5. Soldering head according to one of claims 1 to 4, **characterised in that** on or in the housing (70) a further connection (74) is provided for the supply of air.

6. Soldering head according to one of claims 1 to 5, **characterised in that** in the housing (70) air outlet openings (76, 78) are provided.

7. Soldering head according to claim 6, **characterised in that** at least one of the air outlet openings (78) is arranged in the area of the soldering bar (20).

8. Soldering head according to one of claims 1 to 7, **characterised in that** the soldering bar (20) has a contact surface (26) for a component to be soldered.

9. Soldering head according to claim 8, **characterised in that** the contact surface (26) of the soldering bar (20) is profiled over at least a section.

10. Soldering head according to claim 8 or 9, **characterised in that** the soldering bar (20) presents a thickening (28) in the area of the contact surface (26).

## Revendications

1. Tête de brasage (10) pour un dispositif de brasage à étrier comprenant :
a) un étrier de brasage (20), qui peut être fixé de manière amovible à un support (30) et
b) un transformateur (50) qui présente un noyau d'inductance (51) et un enroulement de fil (52) monté sur le noyau d'inductance (51) ainsi qu'un enroulement secondaire (54),
c) dans laquelle l'enroulement de fil (52) du transformateur (50) peut être connecté à une source de courant et
d) dans laquelle l'étrier de brasage (20) et le support (30) forment l'enroulement secondaire (54) du transformateur (50),
e) dans laquelle le support (30) et le transformateur (50) sont aménagés dans un boîtier (70),
f) dans laquelle l'enroulement primaire (54) du transformateur (50) est connecté à la source de courant via un circuit électronique (80) intégré au boîtier (70),
g) le transformateur (50) présente un noyau de transformateur (51) qui est pourvu d'une ouverture (55) pour réaliser le support (30),
h) l'étrier de brasage (20) conjointement avec le support (30) est un enroulement secondaire fermé en soi (54) qui entoure le noyau d'inductance (51) en regard de l'enroulement primaire (52),
i) dans lequel l'étrier de brasage (20) est relié au support (30) via des ailes (22, 23) latéralement vis-à-vis du noyau d'inductance (51), le support présentant un corps de base (32) sensiblement en forme de tige,
j) le dispositif de brasage à étrier opère selon le procédé à chaleur pulsée, dans lequel l'énergie introduite dans l'étrier de brasage (20) est réglable via une modulation de la largeur d'impulsion.

2. Tête de brasage selon la revendication 1, **caractérisée en ce que** le circuit électronique (80) est ou forme une partie de réseau.

3. Tête de brasage selon la revendication 1 ou la revendication 2, **caractérisée en ce qu'**il est prévu, dans ou sur le boîtier (70), une connexion électrique (72) pour l'enroulement primaire (54) du transformateur (50) ou pour le circuit électronique (80).

4. Tête de brasage selon l'une quelconque des revendications 1 à 3, **caractérisée en ce que** le boîtier (70) est fabriqué dans un matériau thermo-conducteur.

5. Tête de brasage selon l'une quelconque des revendications 1 à 4, **caractérisée en ce qu'**il est prévu dans le boîtier (70) une autre connexion (74) pour l'acheminement d'air.

6. Tête de brasage selon l'une quelconque des revendications 1 à 5, **caractérisée en ce que** des ouvertures de sortie d'air (76, 78) sont ménagées dans le boîtier (70).

7. Tête de brasage selon la revendication 6, **caractérisée en ce qu'**au moins une ouverture de sortie d'air (78) est ménagée dans la zone de l'étrier de brasage (20).

8. Tête de brasage selon l'une quelconque des revendications 1 à 7, **caractérisée en ce que** l'étrier de brasage (20) présente une surface de contact (26) pour une pièce à braser.

9. Tête de brasage selon la revendication 8, **caractérisée en ce que** la surface de contact (26) de l'étrier de brasage (20) est conçue avec un certain profilage au moins par endroits.

10. Tête de brasage selon la revendication 8 ou la revendication 9, **caractérisée en ce que** l'étrier de brasage (20) présente un épaississement ou un renforcement (28) dans la zone de la surface de contact (26).
